# EUROPEAN PATENT APPLICATION

(11) **EP 0 878 849 A2**
(43) Date of publication of application: **18.11.1998**
(21) Application number: 98303505.6
(22) Date of filing: 05.05.1998
(51) Int. Cl.: H01L 29/861

(54) **Power diode**

(30) Priority: 14.05.1997 GB 9709642
(71) Applicant: Mitel Semiconductor Limited, Swindon, Wiltshire SN2 2QW (GB)
(72) Inventor: Crees, David Edward, Welton, Lincoln, LN2 3ND (GB); Rahimo, Munaf Thamin, Lincoln LN6 3LL (GB); Shammas, Noel Yacoub Aziz, Weeping Cross, Stafford, ST17 0SJ (GB)
(74) Representative: Hoste, Colin Francis

(57) **Abstract**

A power diode is provided with regions of semiconductor material of high lifetime and low lifetime. For high frequency operation, low lifetime material is preferable, but this can result in undesirable transient current and voltage spikes. The regions of different lifetime material are spaced apart in a direction parallel to the p-n junction of the diode, and in embodiments of the invention are arranged to intersect the junction. Several configurations are described which produce different voltage-current transfer characteristics in which the effect of unwanted transient signals is reduced.

## Description

This invention relates to semiconductor devices, in which a p-n junction is present to provide a diode action. There is an increasing requirement for power diodes which are able to operate at high frequencies. In order for a power diode to operate at high frequencies, and switch rapidly between conducting and non-conducting states when required, it is desirable that the semiconductor material which comprises the diode is one in which the minority carriers have a low lifetime enabling the diode to switch rapidly from a conductive to a non-conductive state. Such a diode can produce transient current and voltage spikes which are highly undesirable; such a characteristic is sometimes termed "snappy". The expedient of providing the semiconductor material with a higher lifetime characteristic in order to reduce these transient spikes results in higher internal losses, ie heat dissipation, within the diode itself, and hence a loss in operating efficiency.

The present invention seeks to provide an improved semiconductor device.

According to a first aspect of this invention, a semiconductor device includes a planar p-n junction having a plurality of regions of semiconductor material in the vicinity of the junction and which are spaced apart in a direction substantially parallel to the junction in which at least one such region of which has a first minority carrier lifetime which is substantially lower than that of another of the regions having a second minority carrier lifetime, the maximum transverse dimension of the greater lifetime region being less than twice the minority carrier diffusion length within that region.

According to a second aspect of this invention, a semiconductor device includes a p-n junction having a plurality of localised regions of semiconductor material having a first minority carrier lifetime which regions are bounded by a region of semiconductor material having a second carrier minority lifetime which is substantially greater than said first carrier lifetime and which regions extend towards or through said junction, the maximum transverse dimension of the greater lifetime region being less than twice the minority carrier diffusion length within that region.

Preferably the material having the first, lower, lifetime is in the form of a regular matrix of cells of substantially the same area as each other and which are spaced apart by intervening material having the second, greater, lifetime.

Preferably again the semiconductor material is silicon.

The semiconductor device enables a power diode to be fabricated which has a good combination of low on-state (ie conductive) losses and a fast but soft (ie non-snappy) recovery characteristic. This proves to be much more satisfactory than simply providing a more homogeneous semiconductor body of a material having a minority carrier lifetime intermediate the first and second values of the invention. The operating characteristics of such a diode are dependent on the relative cross-sectional areas of the regions of different lifetimes, in the general direction of the plane of the junction.

The invention is further described by way of example with reference to the accompanying drawings, in which:
Figure 1 shows a diagrammatic view of a semiconductor diode,
Figures 2 and 4 show sectional views of further embodiments of the invention,
   and
Figures 3 and 5 are explanatory diagrams relating thereto.

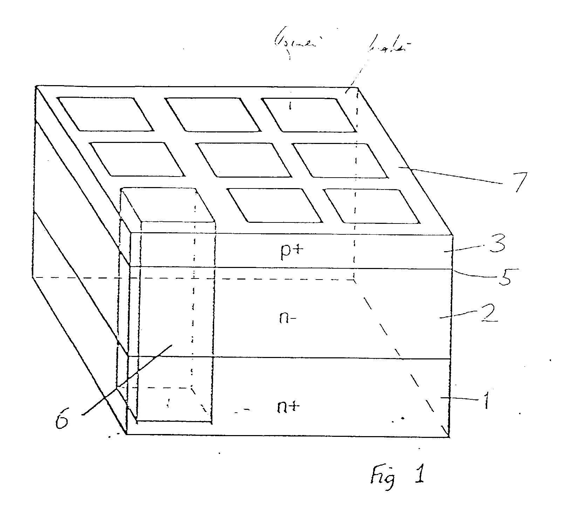

Referring to Figure 1, a semiconductor diode consists of a silicon substrate 1 of n+ conductivity type, having an n- layer 2 formed on it. The top layer 3 of p+ conductivity type overlies it, and the interface between layers 2 and 3 constitutes a p-n junction 5. The upper surface of the layer 3 and the underside of layer 1 are provided with conductive surfaces which act as contact electrodes (not shown) enabling electrical connections to be made to the diode. The layer 2, of relatively high resistivity material, is termed the drift region.

The diode is provided with localised cells 6 which extend vertically through the diode so as to intersect the p-n junction 5, and the composition of these cells 6 is such that the material exhibits a lower minority carrier lifetime than that of the surrounding material 7. As shown, the cells are arranged in a regular array in the form of a matrix set into the surrounding material. The thickness of the material 7 surrounding the cells, is made very small and is less than twice the minority carrier diffusion length within material 7.

Typically, in this example, the diode is designed to operate at a reverse bias of 1800 volts and the cells 6 have a minority carrier lifetime of 230ns and the surrounding material 7 has a lifetime of about 3 µs and a bulk diffusion length of about 70 µm.

After the three layer device comprising layers 1, 2 and 3 has been manufactured so as to have the appropriate conductivity modifier concentrations, which correspond to the higher lifetime value, an apertured metal mask is placed over the upper layer 3. The mask is then irradiated with electrons which penetrate only through the uncovered surface regions to create the low lifetime cells 6 which extend through all three layers 1, 2 and 3. Thus the unradiated material has the high lifetime of about 3 µs and a low resistance, and the radiated cells have a low lifetime of about 230ns and a relatively high resistance.

When the diode is in its forward conduction state, the minority carriers are largely concentrated in the high lifetime region 7, and the electron current has a large value in the high lifetime region 7 near the interface between the n- drift layer 2 and the n+ layer 1, where most of the electrons are recombining with the large number of holes that exist there. Therefore, the forward current flows mainly through the low resistance region 7, dominating the forward steady state characteristic.

Due to the presence of the region 6, the diode has a much smaller stored charge near the p-n junction 5 than would be the case for diodes consisting wholly of the material of region 7.

In the reverse blocking mode, the diode exhibits a low leakage current due to the reduced percentage of the low lifetime channel. The reduction in reverse recovery voltage as compared with a 'snappy' diode is mainly due to the fact that the diode shown in Figure 1 has a large stored charge in the drift layer 2, especially near the n-, n+ interface within the high lifetime channel 7.

Thus, lower forward voltage drops and lower reverse current can be obtained by increasing the percentage area of the low resistance region 7, while faster switching performance is obtained by decreasing it.

Referring to Figure 2, a sectional view is shown of a form of what is termed a drift charge extraction diode (DCE) of the invention. Initially the diode is formed from high lifetime silicon, with an upper p layer 51, an n- drift layer 52, and a lower n+ layer 53 in a manner similar to Figure 1. The low lifetime channels 54 are formed by electron irradiation through a mask, the mask apertures, or windows, being relatively large in this example. Although the cross-sectional shape of the aperture can be square, rectangular, circular or the like in this example, each aperture is square in area.

Instead of electron irradiation, other lifetime modifying techniques can be used, e.g. Pt or Au implantation followed by a controlled rapid thermal anneal.

The widths of both high and low lifetime channels are relatively small, such that the resulting masked high lifetime channel dimensions allow both high and low lifetime regions to interact with each other. Half the width of the high lifetime channel 55 does not exceed the minority carrier diffusion length within that region. The transverse dimension of a cell or channel is about 10 µm, and has a lifetime less than 500ns and that of the intervening high lifetime region is 50 µm with a lifetime of about 0.75 µs. This results in the majority of the diode volume having a high lifetime value. In this example, irradiation doses of 16 to 24 MRAD are used to form the low lifetime channels 54.

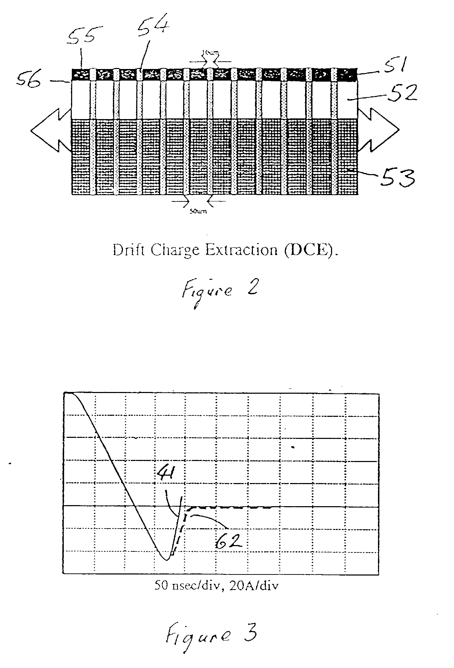

The low lifetime channels 54 ensure low carrier concentration near the pn junction 56 in the high lifetime regions to achieve low reverse recovery charge while maintaining higher carrier concentrations on the other side of the drift layer 52 for softer recovery characteristics. These characteristics are shown in Figure 3 as a broken line 62, the solid line 41 representing a snappy diode. Because of its mode of operation, the diode shown in Figure 2 is referred to as a drift charge extraction (DCE) diode.

As the transverse dimension of the high lifetime regions 55 is very small, ie less than 50 µm, the diode does not operate as though it consists of several elemental diodes in parallel each having the characteristics of a diode with high or low lifetime characteristics as the case may be. Instead, the regions 54 and 55 fully interact, and the minority charge carrier characteristics in high life time region 55 are largely determined by the low lifetime region 54 during a switching phase, as the diffusion length of the minority carriers is greater than twice the transverse dimension of region 55. Thus, any minority charge carrier in a high lifetime region 55 is less than its diffusion length away from region 54, which therefore largely determines the lifetime characteristics of the diode as a whole when the diode is turning off and charge carriers are being extracted from the depletion region of the p-n junction between layers 51 and 52. The low lifetime regions aid in extracting the stored charge near the junction during diode turnoff to achieve low switching losses and ultra soft recovery characteristics.

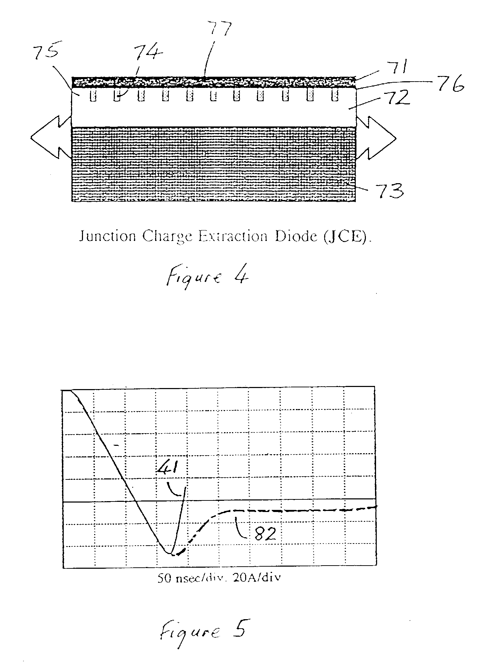

Referring to Figure 4, there is shown a variant, in which the low lifetime channels are such as to exhibit even softer characteristics than the ones obtained for the DCE diode of Figure 2. Using masked Helium or Proton irradiation techniques, with controlled implant energy, the low lifetime channels 74 can be made very short and take the form of buried cells, and in this example are located in the n- drift layer 72 very closes to the pn junction 76. The charge extraction is more concentrated near the junction 76 leaving a higher amount of stored charge near the other side (73) of the drift layer 72 for softer characteristics, as represented by broken line 82 in Figure 5. This diode is termed the junction charge extraction diode (JCE). The buried cells need not be located in the layer 72, but can be formed in the p+ layer 71 instead, or they may lie across the p-n junction 76 itself. These buried cells also act as injection efficiency modifiers with similar beneficial effects on softer recovery due to the lateral redistribution of charge during turn-off.

The mask dimensions are similar to the DCE of Figure 2, but the implantation process is easier to implement, since the ion irradiation used does not require such a thick mask to block the radiation at regions 77, which are unmodified.

Although the invention has been described with particular reference to a diode, it is applicable to other kinds of power semiconductor devices such as an IGBT (Insulated Gate Bipolar Transistor) having a p-n junction in which switching and recovery times are important.

## Claims

1. A semiconductor device including a planar p-n junction having a plurality of regions of semiconductor material in the vicinity of the junction and which are spaced apart in a direction substantially parallel to the junction in which at least one such region of which has a first minority carrier lifetime which is substantially lower than that of another of the regions having a second minority carrier lifetime, the maximum transverse dimension of the greater lifetime region being less than twice the minority carrier diffusion length within that region.

2. A semiconductor device including a p-n junction having a plurality of localised regions of semiconductor material having a first minority carrier lifetime which regions are bounded by a region of semiconductor material having a second carrier minority lifetime which is substantially greater than said first carrier lifetime and which regions extend towards or through said junction, the maximum transverse dimension of the greater lifetime region being less than twice the minority carrier diffusion length within that region.

3. A device as claimed in Claim 2 or 3 and wherein the material having the first, lower, lifetime is in the form of a regular matrix of cells or channels of substantially the same area as each other and which are spaced apart by intervening material having the second, greater, lifetime.

4. A device as claimed in Claim 3 and wherein the lower lifetime material is formed by irradiating selected areas of semiconductor material having the greater lifetime.

5. A device as claimed in any of Claims 2 to 4 and wherein the regions of lower and greater lifetime both intersect said junction.

6. A device as claimed in any of Claims 2 to 4 and wherein the regions of lower lifetime material are in the form of localised cells located in a region of n type material in the vicinity of said junction.

7. A device as claimed in any of the preceding claims and wherein the semiconductor material is silicon.
